# EUROPÄISCHE PATENTSCHRIFT

(11) **EP 1 042 820 B1**
(45) Veröffentlichungstag und Bekanntmachung des Hinweises auf die Patenterteilung: **12.03.2003**
(21) Anmeldenummer: 98965108.8
(22) Anmeldetag: 07.12.1998
(51) Int. Cl.: H01L 39/16

(54) **SUPRALEITERAUFBAU MIT HOCH-T c?-SUPRALEITERMATERIAL, VERFAHREN ZUR HERSTELLUNG DES AUFBAUS SOWIE STROMBEGRENZEREINRICHTUNG MIT EINEM SOLCHEN AUFBAU**
SUPERCONDUCTOR STRUCTURE WITH HIGH-T c? SUPERCONDUCTOR MATERIAL, METHOD FOR PRODUCING SAID STRUCTURE AND CURRENT-LIMITING DEVICE WITH A STRUCTURE OF THIS TYPE
STRUCTURE SUPRACONDUCTRICE EN MATERIAU SUPRACONDUCTEUR A COEFFICIENT DE TEMPERATURE ELEVE, PROCEDE DE PRODUCTION DE CETTE STRUCTURE ET DISPOSITIF DE LIMITATION DE COURANT DOTE D'UNE TELLE STRUCTURE

(30) Priorität: 19.12.1997 DE 19756854
(43) Veröffentlichungstag der Anmeldung: 11.10.2000
(73) Patentinhaber: SIEMENS AKTIENGESELLSCHAFT, 80333 München (DE)
(72) Erfinder: RIES, Günter, D-91056 Erlangen (DE)
(86) Internationale Anmeldenummer: DE9803596
(87) Internationale Veröffentlichungsnummer: WO99033122

(56) Entgegenhaltungen:
- EP-A- 0 292 959
- EP-A- 0 523 374
- PATENT ABSTRACTS OF JAPAN vol. 015, no. 054 (E-1031), 8. Februar 1991 & JP 02 281765 A (FURUKAWA ELECTRIC CO LTD:THE), 19. November 1990
- PATENT ABSTRACTS OF JAPAN vol. 017, no. 561 (C-1119), 8. Oktober 1993 & JP 05 163005 A (MITSUBISHI ELECTRIC CORP), 29. Juni 1993

## Beschreibung

Die Erfindung bezieht sich auf einen Supraleiteraufbau zur Führung eines elektrischen Stromes in einer vorbestimmten Richtung mit wenigstens folgenden Teilen: Der Aufbau weist einen Träger aus metallischem Material sowie eine auf dem Träger befindliche Leiterbahn auf. Diese Leiterbahn enthält zumindest wenigstens eine auf dem Träger abgeschiedene Zwischenschicht aus elektrisch isolierendem Material und wenigstens eine auf der Zwischenschicht abgeschiedene Supraleitungsschicht aus einem Hoch-T_{c}-Supraleitermaterial. Die Erfindung betrifft ferner ein Verfahren zur Herstellung eines entsprechenden Supraleiteraufbaus. Ein solcher Aufbau und ein entsprechendes Herstellungsverfahren gehen aus der *EP 0 292 959 A* hervor. Darüber hinaus betrifft die Erfindung eine Strombegrenzereinrichtung mit einem solchen Supraleiteraufbau.

Es sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und insbesondere eine Flüssig-Stickstoff(LN₂)-Kühltechnik erlauben. Unter solche Metalloxidverbindungen fallen insbesondere Cuprate auf Basis spezieller Stoffsysteme wie z.B. der Typen Y-Ba-Cu-O oder Bi-Sr-Ca-Cu-O, wobei die Bi-Komponente teilweise durch Pb substituiert sein kann. Innerhalb einzelner Stoffsysteme können mehrere supraleitende Hoch-T_{c}-Phasen auftreten, die sich durch die Anzahl der Kupfer-Sauerstoff-Netzebenen bzw. -schichten innerhalb der kristallinen Einheitszelle unterscheiden und die verschiedene Sprungtemperaturen T_{c} aufweisen.

Diese bekannten HTS-Materialien versucht man, auf verschiedenen Substraten für unterschiedliche Anwendungszwecke abzuscheiden, wobei im allgemeinen nach möglichst phasenreinem Supraleitermaterial getrachtet wird. So werden insbesondere metallische Substrate für Leiteranwendungen vorgesehen (vgl. die eingangs genannte EP-A-Schrift).

Bei einem entsprechenden Supraleiteraufbau für Leiteranwendungen wird das HTS-Material im allgemeinen nicht unmittelbar auf einem als Substrat dienenden metallischen Trägerband abgeschieden; sondern dieses Trägerband wird zunächst mit einer dünnen Zwischenschicht, die auch als Pufferschicht (bzw. "Buffer"-Schicht) bezeichnet wird, abgedeckt. Diese Zwischenschicht mit einer Dicke in der Größenordnung von etwa 1 µm soll das Eindiffundieren von Metallatomen aus dem Substrat in das HTS-Material, welche die supraleitenden Eigenschaften verschlechtern könnten, verhindern. Zugleich kann mit dieser Zwischenschicht die Oberfläche geglättet und die Haftung des HTS-Material verbessert werden. Entsprechende Zwischenschichten bestehen im allgemeinen aus Oxiden von Metallen wie Zirkon, Cer, Yttrium, Aluminium, Strontium oder Magnesium und sind somit elektrisch isolierend. In einer diskreten stromtragenden Leiterbahn wie z.B. einem Bandleiter ergibt sich dadurch eine Problematik, sobald der Supraleiter zumindest in Teilbereichen in den normalleitenden Zustand übergeht (sogenanntes "Quenchen"). D.h., der Supraleiter wird strekkenweise resistiv und nimmt so einen Widerstand R an, z.B. indem er sich über die Sprungtemperatur T_{c} erwärmt (sogenannte "Hotspots"). Der im Supraleiter geführte Strom I fließt dann weiter durch das Supraleitermaterial, wobei der Spannungsabfall U=R·I sich nur über dem resistiv gewordenen Bereich ausbildet. In einem bandförmigen, die supraleitende Leiterbahn tragenden Metallsubstrat fällt hingegen die an den Enden angelegte Spannung U gleichmäßig über die gesamte Leiterlänge ab. Die Folge davon können unter Umständen hohe Spannungsdifferenzen in der Leiterbahn über die Zwischenschicht sein. Dies führt wegen der geringen Dicke dieser Schicht unvermeidlich zu elektrischen Durchschlägen und so zu punktueller Zerstörung der Zwischenschicht und gegebenenfalls des Supraleiters. Eine entsprechende Problematik ergibt sich u.a. bei Verwendung von entsprechend aufgebauten Supraleitern in Magnetwicklungen oder in Kabeln. Diese Problematik ist insbesondere auch dann gegeben, wenn mit entsprechenden Leiterbändern resistiven Strombegrenzereinrichtungen erstellt werden. Bei einer solchen Einrichtung wird nämlich der Übergang vom supraleitenden in den normalleitenden Zustand zur Strombegrenzung im Kurzschlußfall ausgenutzt. Es ist hier nicht möglich, die Zwischenschicht ausreichend spannungsfest für die für solche Einrichtungen üblichen Betriebsspannungen im kV-Bereich zu machen.

Aufgrund dieser Problematik wird bei einer bekannten Strombegrenzereinrichtung (vgl. *DE 195 20 205 A*) das HTS-Material auf elektrisch isolierenden, z.B. keramischen Substratplatten aufgebracht. Es ist auch möglich, eine zusätzliche Metallschicht aus einem elektrisch gut leitenden Material wie Au oder Ag als Shunt gegen Durchbrennen an den sogenannten "Hotspots" direkt auf dem HTS-Material abzuscheiden, wodurch das HTS-Material so in einem elektrisch leitenden flächenhaften Kontakt mit der Metallschicht steht (vgl. *DE 44 34 819 C*). Das erwähnte Spannungsproblem besteht in diesem Falle nicht.

Aufgabe der vorliegenden Erfindung ist es, bei einem Supraleiteraufbau mit den eingangs genannten Merkmalen unter Verwendung eines metallischen Trägers die Gefahr von unerwünschten Spannungsdifferenzen in der Leiterbahn über die elektrisch isolierende Zwischenschicht zumindest zu verringern.

Diese Aufgabe wird erfindungsgemäß dadurch gelöst, daß zwischen der Supraleitungsschicht der Leiterbahn und dem Träger wenigstens ein der Leiterbahn zugeordneter, sich in Stromführungsrichtung erstreckender, elektrisch leitender Verbindungsteil ausgebildet ist, mit dem die Supraleitungsschicht mit dem Träger elektrisch parallelgeschaltet ist.

Die mit dieser Ausbildung des Supraleiteraufbaus verbundenen Vorteile sind darin zu sehen, daß der metallische Träger und die Supraleitungsschicht der Leiterbahn in Stromführungsrichtung gesehen zumindest zu einem großen Teil entlang der Länge des Aufbaus in gegenseitigen elektrischen Kontakt gebracht werden und so dort ein Stromübertritt erlaubt wird. An den Verbindungsbereichen wird damit vorteilhaft in der Leiterbahn ein Durchschlag durch die Zwischenschicht unterbunden.

Vorteilhaft kann eine Ausbildung des wenigstens einen elektrisch leitenden Verbindungsteils zwischen der Supraleitungsschicht und dem Träger dadurch vorgesehen werden, daß in dem entsprechenden mindestens einen Verbindungsbereich eine Abscheidung der Zwischenschicht vermieden oder die Zwischenschicht vor der Abscheidung der Supraleitungsschicht entfernt wird. Stattdessen kann auch wenigstens ein sich über den entsprechenden mindestens einen Verbindungsbereich erstreckender metallischer Schichtteil abgeschieden werden.

Außerdem läßt sich vorteilhaft der Supraleiteraufbau dadurch herstellen, daß als Abscheideverfahren für das Supraleitermaterial ein gleichzeitiges thermisches Verdampfen der einzelnen Komponenten des Supraleitermaterials unter Sauerstoffzufuhr, oder ein Laserablationsverfahren, oder ein Sputterverfahren, oder ein chemisches Verdampfungsverfahren, insbesondere mit metallorganischen Komponenten des Supraleitermaterials, oder ein Siebdruckverfahren vorgesehen wird. Mit dem genannten Abscheideverfahren lassen sich auf der Zwischenschicht Supraleitungsschichten mit hoher kritischer Stromdichte erzeugen.

Weiterhin ist es vorteilhaft, wenn zur Abscheidung des Zwischenschichtmaterials ein Abscheideverfahren mit Ionenstrom-Unterstützung (IBAD) vorgesehen wird. Mit diesem Verfahren können insbesondere biaxial texturierte Kristallstrukturen bekannter Zwischenschichtmaterialien erzeugt werden. Das Supraleitermaterial wächst dann vorteilhaft ebenfalls biaxial texturiert auf, so daß durch Wegfall von strombegrenzenden Korngrenzen hohe kritische Stromdichten zu erreichen sind.

Besonders vorteilhaft kann der erfindungsgemäße Supraleiteraufbau zur Ausbildung einer Strombegrenzereinrichtung vorgesehen werden. Denn die Verwendung eines metallischen Trägers für das Supraleitermaterial gewährleistet eine schnelle Wärmeabfuhr an das erforderliche kryogene Medium und so eine entsprechend schnelle Schaltfolge.

Vorteilhafte Ausgestaltungen des erfindungsgemäßen Supraleiteraufbaus, des Verfahrens zu dessen Herstellung sowie der mit diesem Supraleiteraufbau erstellten Strombegrenzereinrichtung gehen aus den jeweils abhängigen Ansprüchen hervor.

Ausführungsbeispiele im Rahmen der Erfindung werden nachfolgend anhand der Zeichnung erläutert. Dabei zeigen jeweils schematisch
- die Figuren 1 und 2: zwei prinzipielle Ausbildungsmöglichkeiten des Supraleiteraufbaus,
- Figur 3: eine spezielle Ausführungsform des Aufbaus nach Figur 2,
- Figur 4: den Stromfluß in einem Supraleiteraufbau im Falle eines Quenches,
- Figur 5: ein aus dem Supraleiteraufbau erstelltes modulartiges Strombegrenzerelement
und
- Figur 6: eine Strombegrenzereinrichtung mit mehreren modulartigen Strombegrenzerelementen nach Figur 5.

In den Figuren sind sich entsprechende Teile mit denselben Bezugszeichen versehen.

Bei der Gestaltung des Supraleiteraufbaus nach der Erfindung wird von an sich bekannten Ausführungsformen (vgl. die eingangs genannte EP 0 292 959 A) ausgegangen, wie sie insbesondere auch für supraleitende Strombegrenzereinrichtungen (vgl. die ferner genannte *DE 195 20 205 A oder* die *EP 0 523 374 A)* vorgesehen werden. Der erfindungsgemäße Supraleiteraufbau umfaßt deshalb zumindest: einen auch als Substrat zu bezeichnenden Träger und wenigstens eine darauf befindliche Leiterbahn. Diese Leiterbahn umfaßt wenigstens eine auf dem Träger abgeschiedene, auch als Pufferschicht zu bezeichnende Zwischenschicht sowie eine auf dieser Zwischenschicht aufgebrachte Schicht aus einem HTS-Material. Beide Schichten sind zu der Leiterbann strukturiert. Für den Träger wird eine Platte oder ein Band oder sonstige Struktur aus einem metallischen Material mit einer an sich beliebigen Dicke und den für den jeweiligen Anwendungsfall geforderten Abmessungen seiner Fläche verwendet. Als metallische Materialien kommen hier alle als Träger für HTS-Materialien bekannten elementaren Metalle oder Legierungen dieser Metalle in Frage. Beispielsweise sind Cu, Al oder Ag oder deren Legierungen mit einem der Elemente als Hauptkomponente oder Stähle sowie spezielle NiMo-Legierungen, insbesondere mit dem Handelsnamen "Hastelloy", geeignet.

Um ein für eine hohe kritische Stromdichte J_{c} des HTS-Materials erforderliches texturiertes, insbesondere epitaktisches Wachstum des HTS-Materials zu ermöglichen, sollte die mindestens eine Zwischenschicht aus einem ein solches Wachstum gewährleistenden Material bestehen. Deshalb ist eine Zwischenschicht mit einer an die kristalline Abmessung des HTS-Materials angepaßten Textur besonders geeignet. Auf alle Fälle soll das Zwischenschichtmaterial elektrisch isolierend sein. Vorteilhaft ist biaxial texturiertes, mit Yttrium stabilisiertes Zirkonoxid (Abkürzung: "YSZ"). Daneben sind auch andere, bekannte Pufferschichtmaterialien wie z.B. CeO₂, YSZ + CeO₂(als Doppelschicht), Pr₆O₁₁, MgO, YSZ + zinndotiertes In₂O₃ (als Doppelschicht), SrTiO₃ oder La₁₋ₓCaₓMnO₃ geeignet. Eines oder mehrere dieser Materialien wird in an sich bekannter Weise auf der Oberfläche des Trägers abgeschieden. Hierzu kann vorteilhaft ein sogenanntes IBAD-Verfahren (Ion Beam Assisted Deposition-Verfahren) vorgesehen werden. Selbstverständlich sind auch andere Verfahren geeignet wie z.B. ein Sputtern oder eine Laserablation unter einem vorbestimmten Winkel. Die Abscheidung des Zwischenschichtmaterials erfolgt dabei in den meisten Fällen bei erhöhten Temperaturen am Träger. Die Schichtdicke der so erzeugten texturierten Zwischenschicht liegt im allgemeinen zwischen 0,1 und 2 µm.

Auf der Zwischenschicht wird anschließend das HTS-Material mit Hilfe bekannter Abscheideverfahren unter Aufheizung des Trägers mit einer Dicke im allgemeinen bis zu einigen Mikrometern aufgebracht. Die gängigsten der hierfür geeigneten Verfahren der PVD(Physical Vapor Deposition)-Technik sind die Laserablation unter Einsatz eines gepulsten Lasers, das Magnetron-Sputtern oder vorzugsweise ein thermisches Co-Verdampfen (= gleichzeitiges Verdampfen der Komponenten des HTS-Materials unter Sauerstoffzufuhr). Auch CVD(Chemical Vapor Deposition)-Verfahren, insbesondere unter Verwendung von metallorganischen Ausgangsmaterialien, sind geeignet. Stattdessen kann auch ein an sich bekanntes Siebdruckverfahren vorgesehen werden.

Als HTS-Materialien kommen alle bekannten metalloxidischen Hoch-T_{c}-Supraleitermaterialien in Frage, die insbesondere eine LN₂-Kühltechnik erlauben. Entsprechende Materialien sind beispielsweise YBa₂Cu₃O₇₋ₓ bzw. RBa₂Cu₃C₇₋ₓ (mit R = Seltenes Erdmetall), HgBa₂CaCu₂O₆₊ₓ, HgBa₂Ca₂Cu₃O₈₊ₓ, Bi₂Sr₂CaCu₂O₈₊ₓ oder (Bi,Pb)₂Sr₂Ca₂Cu₃O₁₀₊ₓ. Die HTS-Schicht kann mit mindestens einer weiteren Schicht wie z.B. einer Schutzschicht oder einer als Shuntwiderstand dienenden Schicht abgedeckt sein.

Die Zwischenschicht und die auf ihr befindliche HTS-Schicht sind zu mindestens einer Leiterbahn strukturiert. Es können auch entsprechend diskret abgeschiedene Schichtbahnen vorgesehen sein.

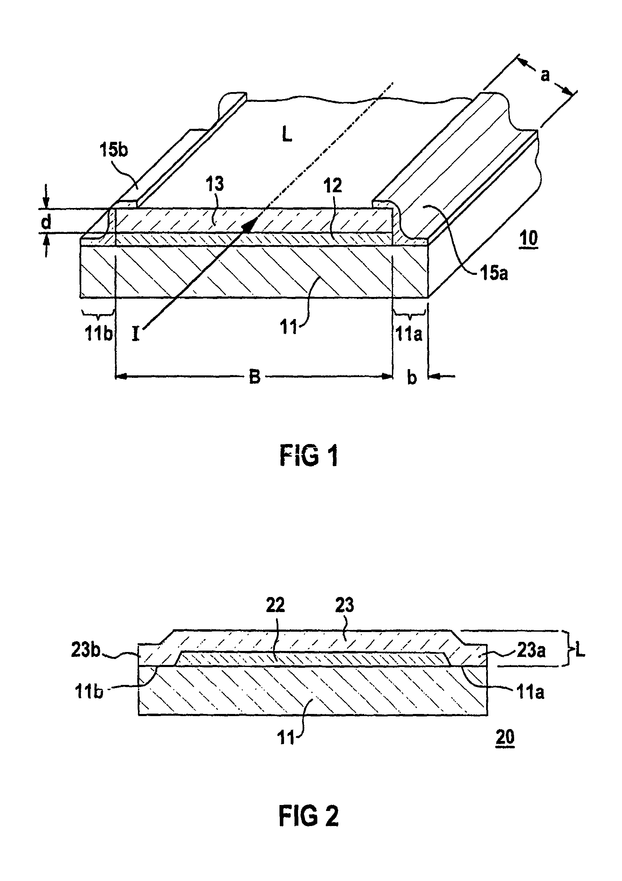

Ein entsprechender Supraleiteraufbau nach der Erfindung aus bandförmigem Träger, Zwischenschicht und HTS-Schicht ist auch dem in Figur 1 im Querschnitt veranschaulichten Ausführungsbeispiel zugrundegelegt und allgemein mit 10 bezeichnet. Dabei sind der Träger mit 11, die Zwischenschicht mit 12 und die HTS-Schicht mit 13 bezeichnet, Die Zwischenschicht 12 und die HTS-Schicht 13 bilden eine streifenförmige Leiterbahn L. Erfindungsgemäß soll zwischen der HTS-Schicht 13 und dem Träger 11 der Leiterbahn L wenigstens ein elektrisch leitender Verbindungsteil vorhanden sein, der sich in der durch einen Pfeil angedeuteten Führungsrichtung eines elektrischen Stromes I erstreckt. D.h., in diese Richtung gesehen soll mit dem wenigstens einen Verbindungsteil über die gesamte Länge des Aufbaus entweder ununterbrochen eine Parallelschaltung der Supraleitungsschicht mit dem Träger erzeugt sein. Es ist aber auch möglich, daß in diese Richtung gesehen kurze, regelmäßig verteilte Unterbrechungen der Verbindung zwischen diesen Teilen vorgesehen werden, ohne daß die erwünschte Parallelschaltung wesentlich beeinträchtigt wird. Gemäß dem gezeigten Ausführungsbeispiel werden zwei Verbindungsteile in Form von seitlichen, streifenförmigen Schichten 15a und 15b aus einem elektrisch gut leitenden Metall wie Ag, Au oder Cu gebildet. Zu Erzeugung dieser streifenförmigen Metallschichten 15a und 15b wird in mindestens einem der beiden seitlichen, streifenförmigen Randbereiche 11a und 11b des bandförmigen Trägers 11 die Pufferschicht 12 beim Abscheiden beispielsweise durch eine Schattenmaske entweder nicht erst aufgebracht oder danach durch mechanische oder chemische Verfahren wie Schleifen, Ätzen, Verdampfen mit einem Laserstrahl entfernt. Die Breite b dieser nunmehr blanken Randbereiche 11a und 11b des Trägers sollte vorteilhaft jeweils mindestens das Fünffache der Dicke d der HTS-Schicht 13 betragen, vorzugsweise wesentlich darüber liegen bis zum Hundertfachen. Der Kontakt zwischen der HTS-Schicht 13 und dem Träger 11 geschieht dann durch Aufbringen der streifenförmigen Metallschichten 15a und 15b, die sich seitlich über die Zwischenschicht 12 hinweg erstrecken und den jeweiligen Randbereich der Supraleiterschicht und die blanken Randbereiche 11a und 11b des Trägers überdecken. Die HTS-Schicht kann wie die Zwischenschicht in den Randbereichen 11a und 11b entfernt worden sein oder sich auch darüber hinaus erstrecken. Im allgemeinen ist die seitliche Ausdehnung a der Metallschichten 15a und 15b klein, vorzugsweise 1/10 bis 1/100, gegenüber der Breite B der streifenförmigen Supraleiterschicht 13 bzw. der darunterliegenden Zwischenschicht 12. Die maximale Dicke dieser Metallschichten ist im allgemeinen höchstens gleich der Dicke d der HTS-Schicht 13.

Bei dem in Figur 2 gezeigten, allgemein mit 20 bezeichneten Supraleiteraufbau nach der Erfindung erstreckt sich die HTS-Schicht 23 seiner Leiterbahn L seitlich über die schmälere Zwischenschicht 22 hinaus bis zur ganzen Breite des Trägers 11. Bei dieser Ausführungsform sind folglich keine besonderen Metallstreifen zur Kontaktierung erforderlich, sondern die HTS-Schicht steht in den Randbereichen 11a und 11b des Trägers 11 in direktem elektrischen Kontakt mit dem Träger, indem sie die Zwischenschicht 22 seitlich überlappt. Dabei können in der Umgebung der Kante der Zwischenschicht 22 und auf den Randbereichen 11a und 11b die supraleitenden Kenngrößen wie die kritische Stromdichte J_{c} und/oder die kritische Temperatur T_{c} in den entsprechenden Randstreifen 23a und 23b der HTS-Schicht 23 reduziert sein. Gegebenenfalls kann hier sogar das Material der Schicht 13 normalleitend sein.

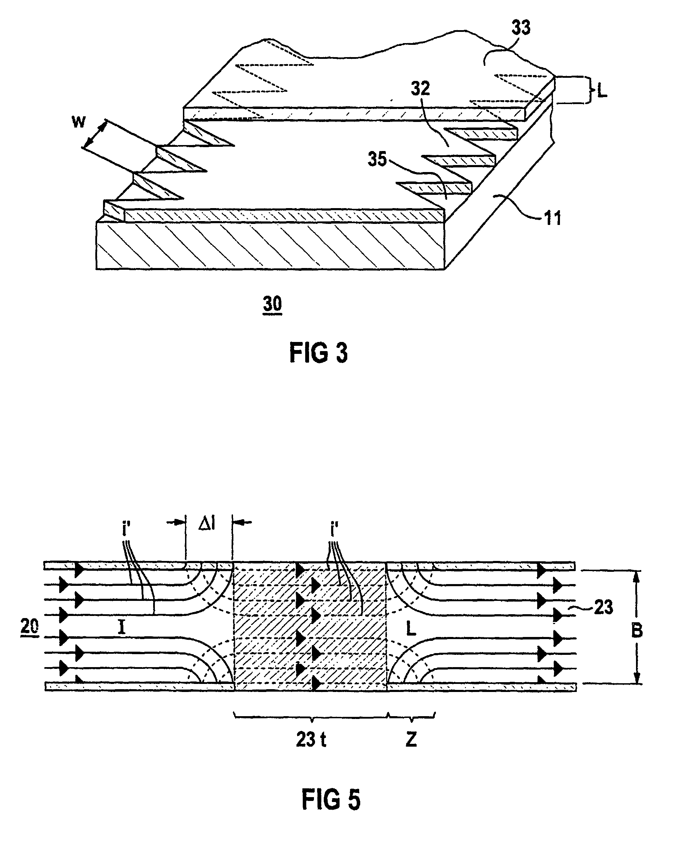

Abweichend von den in den Figuren 1 und 2 dargestellten Ausführungsformen eines erfindungsgemäßen Supraleiteraufbaus 10 bzw. 20, bei dem sich die elektrisch leitende Verbindung in Stromführungsrichtung gesehen zwischen der HTS-Schicht einer Leiterbahn L und dem metallischen Träger praktisch über die gesamte axiale Länge des Aufbaus erstreckt, kann auch eine Kontaktierung dieser beiden Teile des Aufbaus mit regelmäßigen Unterbrechungen in dieser Richtung vorgesehen werden. Figur 3 zeigt einen entsprechenden Supraleiteraufbau 30. Bei diesem Aufbau wird wie gemäß der Ausführungsform nach Figur 2 die Kontaktierung durch die HTS-Schicht 33 selbst gewährleistet. Hierzu sind in einer Zwischenschicht 32 in Stromführungsrichtung gesehen in regelmäßigen Abständen hintereinander beispielsweise dreiecksförmige Ausnehmungen 35 vorhanden, in denen die HTS-Schicht 33 unmittelbar auf dem Träger 11 aufliegt. Die Zwischenschicht 32 hat also in diesem Falle eine etwa zahnartige seitliche Kontur, wobei die mittlere Zahnweite w vorteilhaft mindestens 5-mal so groß ist wie die Dikke d der HTS-Schicht 33. Auf diese Weise kann vorteilhaft eine Verlängerung der Länge der Überhitzungszonc zwischen dem supraleitenden Material der Leiterbahn und dem metallischen Träger erreicht werden, wobei der Übergangswiderstand entsprechend verringert ist.

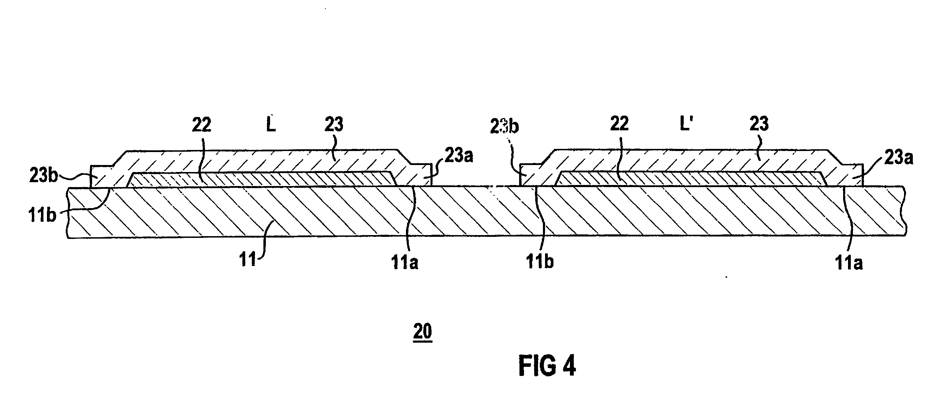

Bei den anhand der Figuren 1 bis 3 gezeigten Ausführungsbeispielen eines erfindungsgemäßen Supraleiteraufbaus wurde davon ausgegangen, daß auf einem Träger 11 eine einzige streifenförmige Leiterbahn L ausgebildet ist und der Träger zusätzlich eine an die Streifenform der Leiterbahn angepaßte Form hat. Selbstverständlich sind für einen erfindungsgemäßen Supraleiteraufbau Träger auch geeignet, deren Breite verhältnismäßig groß ist. Bei entsprechender hinreichender Ausdehnung des Trägers können dann auch mehrere Leiterbahnen auf diesem angeordnet sein. Figur 4 zeigt in Figur 2 entsprechender Darstellung einen solchen Supraleiteraufbau, bei dem sich zwei parallel verlaufende Leiterbahnen L und L' mit jeweils einem Schichtaufbau gemäß Figur 2 auf einem gemeinsamen Träger 11 befinden.

Ein Figur 4 entsprechender Querschnitt würde sich auch dann ergeben, wenn auf dem Träger eine einzige Leiterbahn mit schleifenförmiger oder U-förmiger oder mäanderförmiger Gestalt ausgebildet ist.

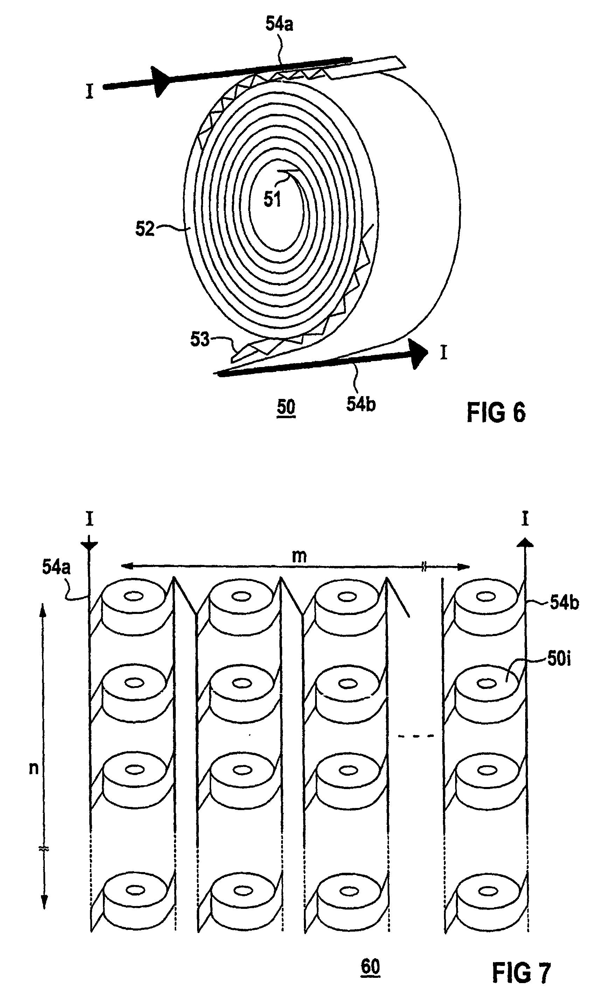

Figur 5 zeigt eine Aufsicht auf einen streifenförmigen Supraleiteraufbau gemäß Figur 1 oder Figur 2. Beispielsweise sei der Aufbau 20 nach Figur 2 mit Leiterbahn L angenommen. Eine durch eine Schattierung angedeutetes Teilstrecke 23t der HTS-Schicht 23 dieser Leiterbahn sei normalleitend (resistiv) geworden. Der sich dann einstellende Fluß des Stromes I ist durch Stromlinien angedeutet, wobei die Stromlinien in der HTS-Schicht 23 mit i bezeichnet und durch durchgezogene Linien veranschaulicht sind, während die sich durch den Träger erstreckenden Stromlinien i' gestrichelt gezeichnet sind. Ist der Widerstand der resistiven Teilstrecke 23t groß gegenüber der parallelen Strecke des Trägerbandes, weicht der größte Teil des Stromes I parallel zu ersterer über die elektrische Verbindung der Randstreifen 23a und 23b an den Kanten in den metallischen Träger aus. Eine Analyse der zweidimensionalen Stromverteilung in einem bandförmigen Supraleiteraufbau ergibt, daß eine Übertrittszone Z etwa eine axiale Ausdehnung Δl = B/π hat, wobei B die Breite der HTS-Schicht ist. Auf diese Weise wird eine Spannungsdifferenz über die isolierende Zwischenschicht 22 der Leiterbahn L auf eine verträgliche Größe im Bereich von einigen Volt reduziert. Der metallische Träger wirkt zudem als Shuntwiderstand zum Supraleiter und erspart z.B. in einer Strombegrenzereinrichtung vorteilhaft ein zusätzliches Aufbringen eines niederohmigen Filmes aus gut leitendem Material wie Ag oder Au auf der Oberfläche der HTS-Schicht, um gegebenenfalls eine unzulässige Aufheizung der Supraleiterstrecke in einem vorzeitig normalleitend gewordenen "Hotspot" zu vermeiden.

Besonders vorteilhaft kann der erfindungsgemäße Supraleiteraufbau für eine resistive Strombegrenzereinrichtung vorgesehen werden. Hierzu wird beispielsweise ein großflächiger plattenförmiger Aufbau oder, wie nachfolgend angenommen, ein Bandleitertyp gemäß einer der Ausführungsformen nach den Figuren 1 und 3 zugrundegelegt, bei dem auf einer vorzugsweise texturierten Zwischenschicht (Pufferschicht) seiner Leiterbahn L eine YBa₂Cu₃O₇₋ₓ-Schicht von etwa 0,3 bis 10 µm Dicke aufgebracht ist. Der entsprechende Bandleiter trägt dann den Strom bis zum Erreichen des kritischen Stromes J_{c} widerstandsfrei und besitzt nach einem Normalleitendwerden (Quench) durch J_{c}-Überschreitung einen genügend hohen Widerstand, um im Kurzschlußfall einen Fehlerstrom wirksam begrenzen zu können. Das Metallband des Trägers wirkt dabei gleichzeitig als Shunt zur Supraleiterschicht und begrenzt den Temperaturanstieg in vorzeitig normalleitend gewordenen "Hotspots". Um die Länge des Bandleiters möglichst klein zu halten, sollte sein Träger möglichst dünn sein, insbesondere eine Dicke zwischen 0,03 und 0,1 mm aufweisen, und aus einem Metall mit hohem spezifischen elektrischen Widerstand wie insbesondere aus Hastelloy bestehen. Vorteilhaft kann gemäß der Darstellung nach Figur 6 durch paralleles Wickeln von an einem gemeinsamen Ende 51 elektrisch miteinander verbundenen Bandleitern 20 und 20' zu einem bifilaren Scheibenwickel 52 ein induktivitätsarmes, modulartiges Begrenzerelement 50 gebildet werden. Zwischen benachbarten Bandlagen des Wickels 52 sind Isolierbänder 53 zur elektrische Isolation eingelegt, die beispielsweise durch eine gewellte oder gerippte Struktur zugleich einen erleichterten Zutritt eines Kühlmittels zu den Bandleitern zum Zweck einer schnellen Wiederabkühlung nach einem Schaltvorgang bewirken. In der Figur sind ferner noch Anschlußleiter 54a und 54b zum elektrischen Anschluß des Bandleiterwickels 52 bzw. zur Zufuhr und Ableitung eines elektrischen Stromes I angedeutet.

Mit mehreren solcher modulartigen Strombegrenzerelementen 50i (mit i = 1.... n·m) läßt sich eine Strombegrenzereinrichtung aufbauen, die in Figur 7 angedeutet und mit 60 bezeichnet ist. Durch ein n-faches paralleles Verschalten mehrerer solcher Elemente mit Nennstrom I und Nennspannung U können dann Strombegrenzereinrichtungen für spezifische Nennströme n·I und durch eine m-fache Serienschaltung für Nennspannungen m·U gebildet werden.

Den nachfolgend in Form einer Tabelle zusammengestellten Angaben eines konkreten Ausführungsbeispieles ist eine Strombegrenzereinrichtung 60 gemäß Figur 7 zugrundegelegt:

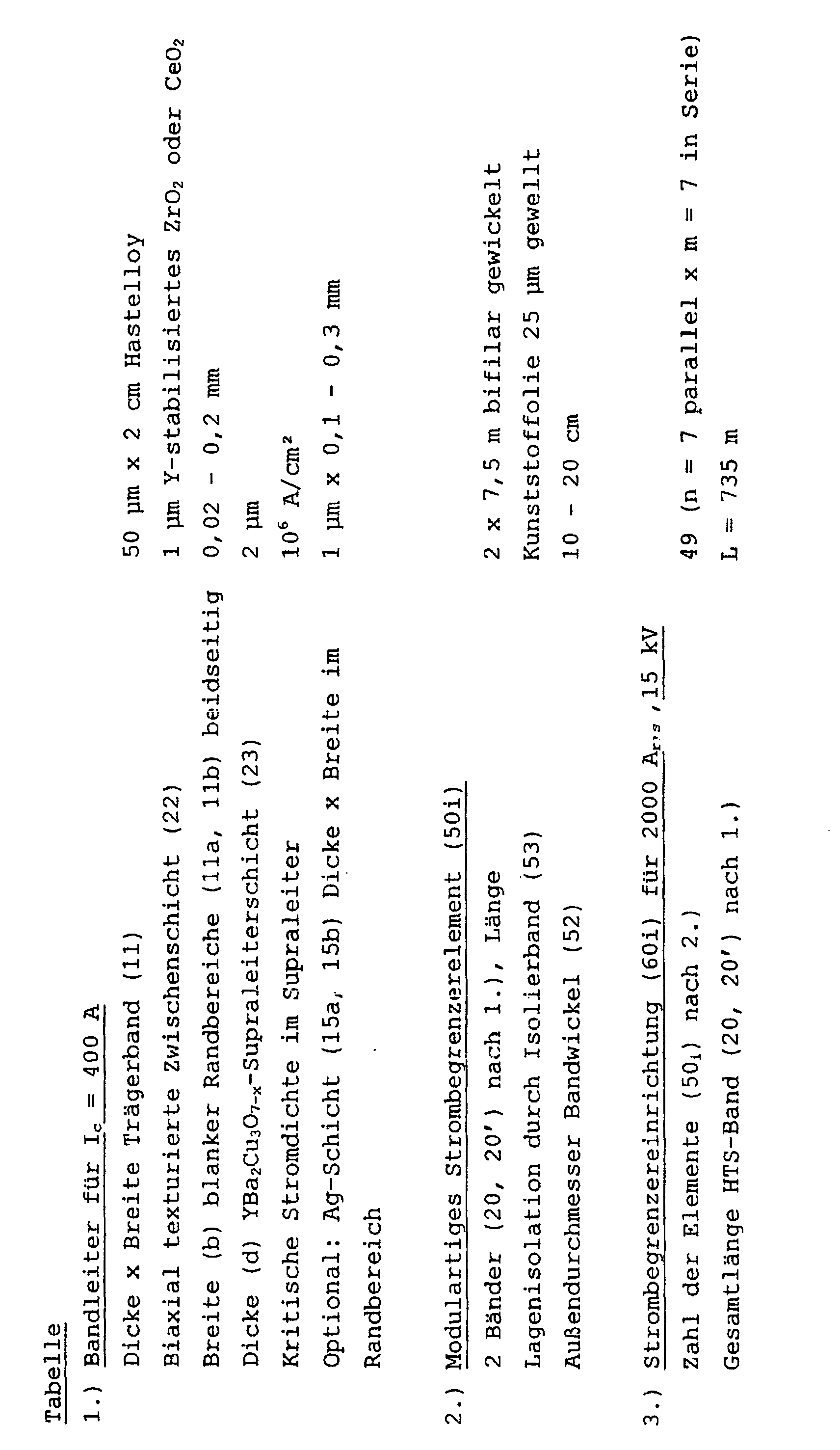

Gemäß den vorstehenden Ausführungsbeispielen wurde von einer Parallelschaltung zwischen der Supraleitungsschicht einer Leiterbahn und dem Träger jeweils am Rande der Supraleitungsschicht ausgegangen. Dies ist jedoch nicht unbedingt erforderlich. So ist es auch möglich, daß in die Supraleitungsschicht sich in Stromführungsrichtung erstreckende Aussparungen oder Gräben oder Löcher eingearbeitet sind, an deren Rändern die erfindungsgemäße Parallelschaltung vorgenommen wird. Z.B. können sich derartige Aussparungen in der Mitte einer streifenförmigen Supraleitungsschicht erstrecken. Dabei muß aber auf alle Fälle gewährleistet sein, daß erfindungsgemäß jede Leiterbahn nur ihr zugeordnete Verbindungsteile gemäß den Figuren 1 bis 3 aufweist.

## Patentansprüche

1. Supraleiteraufbau zur Führung eines elektrischen Stromes in einer vorbestimmten Richtung mit wenigstens folgenden Teilen:
- einem Träger aus metallischen Material,
sowie
- einer auf dem Träger befindlichen Leiterbahn, die zumindest
• wenigstens eine auf dem Träger abgeschiedene Zwischenschicht aus elektrisch isolierendem Material
und
• wenigstens eine auf der Zwischenschicht abgeschiedene Supraleitungsschicht aus einem Hoch-T_{c}-Supraleitermaterial enthält,
**dadurch gekennzeichnet, daß** zwischen der Supraleitungsschicht (13, 23, 33) der Leiterbahn (L, L') und dem Träger (11) wenigstens ein der Leiterbahn zugeordneter, sich in Stromführungsrichtung erstreckender, elektrisch leitender Verbindungsteil der Leiterbahn ausgebildet ist, mit dem die Supraleitungsschicht mit dem Träger elektrisch parallelgeschaltet ist.

2. Aufbau nach Anspruch 1, **dadurch gekennzeichnet, daß** als der mindestens eine Verbindungsteil eine streifenförmige Metallschicht (15a, 15b) vorgesehen ist, die sich seitlich von der Supraleitungsschicht (13) zu einem Randbereich (11a, 11b) des Trägers (11) erstreckt.

3. Aufbau nach Anspruch 1, **dadurch gekennzeichnet, daß** als der mindestens eine Verbindungsteil ein die Zwischenschicht (22, 32) seitlich überlappender Randstreifen (23a, 23b) der Supraleitungsschicht (23) vorgesehen ist, der auf einem entsprechenden Randbereich (11a, 11b) des Trägers (11) aufliegt.

4. Aufbau nach Anspruch 3, **dadurch gekennzeichnet, daß** die Zwischenschicht (32) mit seitlichen Ausnehmungen (35) versehen ist, in denen die Supraleitungsschicht (33) auf dem Träger (11) aufliegt.

5. Aufbau nach einem der vorangehenden Ansprüche, **gekennzeichnet durch** einen Träger (11) aus Cu, Al oder Ag oder deren Legierungen oder aus einem Stahl, insbesondere aus einer NiMo-Legierung.

6. Aufbau nach einem der vorangehenden Ansprüche, **gekennzeichnet durch** mindestens eine Zwischenschicht (12, 22, 32) mit einer an die kristallinen Abmessungen des Supraleitermaterials angepaßter Textur.

7. Aufbau nach Anspruch 6, **gekennzeichnet durch** mindestens eine Zwischenschicht (12, 22, 32) aus biaxial texturiertem, mit Yttrium-stabilisiertem ZrO₂ oder CeO₂.

8. Aufbau nach einem der vorangehenden Ansprüche, **gekennzeichnet durch** mehrere diskrete Leiterbahnen (L, L') auf einem gemeinsamen Träger (11).

9. Verfahren zur Herstellung eines Supraleiteraufbaus nach einem der vorangehenden Ansprüche, **dadurch gekennzeichnet, daß** zur Ausbildung des wenigstens einen Verbindungsteils zwischen der Supraleitungsschicht (13, 23, 33) und dem Träger (11) in dem mindestens einen Verbindungsbereich eine Abscheidung der Zwischenschicht vermieden oder die Zwischenschicht vor der Abscheidung der Supraleitungsschicht entfernt wird.

10. Verfahren zur Herstellung eines Supraleitungsaufbaus nach einem der Ansprüche 1 bis 8, **dadurch gekennzeichnet, daß** zur Ausbildung des mindestens einen Verbindungsteils zwischen der Supraleitungsschicht (13) und dem Träger (11) wenigstens eine sich über den Verbindungsbereich erstreckende streifenförmige Metallschicht (15a, 15b) abgeschieden wird.

11. Verfahren nach Anspruch 9 oder 10, **dadurch gekennzeichnet, daß** als Abscheideverfahren für das Supraleitermaterial ein gleichzeitiges thermisches Verdampfen der einzelnen Komponenten des Supraleitermaterials unter Sauerstoffzufuhr, oder ein Laserablationsverfahren, oder ein Sputterverfahren oder ein chemisches Verdampfungsverfahren, insbesondere mit metallorganischen Komponenten des Supraleitermaterials, oder ein Siebdruckverfahren vorgesehen wird.

12. Verfahren nach einem der Ansprüche 9 bis 11, **dadurch gekennzeichnet, daß** zur Abscheidung des Zwischenschichtmaterials ein Abscheideverfahren mit Ionenstrom-Unterstützung (IBAD) oder ein Sputterverfahren oder ein Laserablationsverfahren vorgesehen wird.

13. Strombegrenzereinrichtung, **gekennzeichnet durch** mindestens einen Supraleiteraufbau (10, 20, 30) nach einem der Ansprüche 1 bis 8.

14. Strombegrenzereinrichtung nach Anspruch 13, **gekennzeichnet durch** eine elektrische Zusammenschaltung mehrerer modulartiger Strombegrenzerelemente (50i), die jeweils einen Supraleiteraufbau nach einem der Ansprüche 1 bis 8 aufweisen.

15. Strombegrenzereinrichtung nach Anspruch 14, **dadurch gekennzeichnet, daß** jedes Strombegrenzerelement (50i) einen Wickel (52) aus bifilar gewikkeltem Leiterband (20, 20') mit dem Supraleiteraufbau aufweist.

16. Strombegrenzereinrichtung nach Anspruch 15, **gekennzeichnet durch** Bandleiterwickel (52) mit den Zutritt eines Kühlmittels erleichternden Isolierbändern (53) zwischen benachbarten Leiterbandlagen.

## Claims

1. Superconductor construction for conducting an electric current in a predetermined direction, having at least the following parts:
- a support made from metallic material,
and
- a conductor track which is located on the support and at least contains
• at least one interlayer which is deposited on the support and is made from electrically insulating material,
and
• at least one superconducting layer which is deposited on the interlayer and is made from a high T_{c} superconductor material,
**characterized in that** at least one electrically conductive connecting part, which is assigned to the conductor track and extends in the current-conducting direction, of the conductor track is formed between the superconducting layer (13, 23, 33) of the conductor track (L, L') and the support (11), by means of which connecting part the superconducting layer is electrically connected in parallel with the support.

2. Construction according to Claim 1, **characterized in that** the at least one connecting part is provided in the form of a strip-like metal layer (15a, 15b) which extends laterally from the superconducting layer (13) to an edge area (11a, 11b) of the support (11).

3. Construction according to Claim 1, **characterized in that** the at least one connecting part is provided in the form of an edge strip (23a, 23b), which laterally overlaps the interlayer (22, 32), of the superconducting layer (23), which edge strip rests on a corresponding edge area (11a, 11b) of the support (11).

4. Construction according to Claim 3, **characterized in that** the interlayer (32) is provided with lateral recesses (35), in which the superconducting layer (33) rests on the support (11).

5. Construction according to one of the preceding claims, **characterized by** a support (11) made from Cu, Al or Ag or their alloys or from a steel, in particular from an NiMo alloy.

6. Construction according to one of the preceding claims, **characterized by** at least one interlayer (12, 22, 32) with a texture which is matched to the crystalline dimensions of the superconductor material.

7. Construction according to Claim 6, **characterized by** at least one interlayer (12, 22, 32) made from biaxially textured, yttrium-stabilized ZrO₂ or CeO₂.

8. Construction according to one of the preceding claims, **characterized by** a plurality of discrete conductor tracks (L, L') on a common support (11).

9. Process for producing the superconductor construction according to one of the preceding claims, **characterized in that**, to form the at least one connecting part between the superconducting layer (13, 23, 33) and the support (11), in the at least one connecting region deposition of the interlayer is avoided or the interlayer is removed prior to the deposition of the superconducting layer.

10. Process for producing the superconducting construction according to one of Claims 1 to 8, **characterized in that**, to form the at least one connecting part between the superconducting layer (13) and the support (11), at least one strip-like metal layer (15a, 15b) which extends over the connecting region is deposited.

11. Process according to Claim 9 or 10, **characterized in that** the deposition process for the superconductor material provided is simultaneous thermal vapour deposition of the individual components of the superconductor material while oxygen is being supplied, or a laser ablation process, or a sputtering process, or a chemical vapour deposition process, in particular with organometal components of the superconductor material, or a screen-printing process.

12. Process according to one of Claims 9 to 11, **characterized in that** an ion beam assisted deposition (IBAD) process or a sputtering process or a laser ablation process is provided for deposition of the interlayer material.

13. Current limiter device, **characterized by** at least one superconductor construction (10, 20, 30) according to one of Claims 1 to 8.

14. Current limiter device according to Claim 13, **characterized by** electrical interconnection of a plurality of modular current limiter elements (50i) which each have a superconductor construction according to one of Claims 1 to 8.

15. Current limiter device according to Claim 14, **characterized in that** each current limiter element (50i) has a winding (52) comprising bifilar-wound conductor strip (20, 20') having the superconductor construction.

16. Current limiter device according to Claim 15, **characterized by** strip conductor windings (52) with insulating strips (53), which make it easier for a coolant to gain access, between adjacent conductor strip layers.

## Revendications

1. Structure supraconductrice pour conduire un courant électrique dans une direction prédéterminée, comportant au moins les parties suivantes :
- un support en un matériau métallique,
ainsi que
- une piste conductrice située sur le support et contenant
• au moins une couche intermédiaire en un matériau électriquement isolant, qui a été déposée sur le support
et
• au moins une couche supraconductrice en un matériau supraconducteur à coefficient de température T_{c} élevé, qui a été déposée sur la couche intermédiaire,
**caractérisée par le fait qu'**il est prévu entre la couche supraconductrice (13, 23, 33) de la piste conductrice (L, L') et le support (11) au moins une partie de liaison, conductrice d'électricité qui est associée à la piste conductrice, qui s'étend dans le sens de passage du courant et avec laquelle la couche supraconductrice est branchée électriquement en parallèle avec le support.

2. Structure selon la revendication 1, **caractérisée par le fait qu'**il est prévu comme partie de liaison une couche métallique en forme de ruban (15a, 15b) qui s'étend latéralement de la couche supraconductrice (13) à une zone marginale (11a, 11b) du support (11).

3. Structure selon la revendication 1, **caractérisée par le fait qu'**il est prévu comme partie de liaison une bande marginale (23a, 23b) de la couche supraconductrice (23), laquelle bande marginale chevauche latéralement la couche intermédiaire (22, 32) et repose sur une zone marginale correspondante (11a, 11b) du support (11).

4. Structure selon la revendication 3, **caractérisée par le fait que** la couche intermédiaire (32) est munie d'évidements latéraux (35) dans lesquels la couche supraconductrice (33) repose sur le support (11).

5. Structure selon l'une des revendications précédentes, **caractérisée par** un support (11) en Cu, Al ou Ag ou leurs alliages ou en acier, notamment en un alliage NiMo.

6. Structure selon l'une des revendications précédentes, **caractérisée par** au moins une couche intermédiaire (12, 22, 32) ayant une texture adaptée aux dimensions cristallines du matériau supraconducteur.

7. Structure selon la revendication 6, **caractérisée par** au moins une couche intermédiaire (12, 22, 32) en ZrO₂ ou CeO₂ stabilisé à l'yttrium et à texture biaxiale.

8. Structure selon l'une des revendications précédentes, **caractérisée par** plusieurs pistes conductrices discrètes (L, L') sur un support commun (11).

9. Procédé pour la fabrication d'une structure supraconductrice selon l'une des revendications précédentes, **caractérisé par le fait que**, pour la conception de la ou des parties de liaison entre la couche supraconductrice (13, 23, 33) et le support (11), dans la ou les zones de liaisons, on évite un dépôt de la couche intermédiaire ou on enlève la couche intermédiaire avant le dépôt de la couche supraconductrice.

10. Procédé pour la fabrication d'une structure supraconductrice selon l'une des revendications 1 à 8, **caractérisé par le fait que**, pour la conception de la ou des parties de liaison entre la couche supraconductrice (13) et le support (11), on dépose au moins une couche métallique en forme de bande (15a, 15b) s'étendant sur la zone de liaison.

11. Procédé selon la revendication 9 ou 10, **caractérisé par le fait qu'**on prévoit comme procédé de dépôt pour le matériau supraconducteur une vaporisation thermique simultanée des différents composants du matériau supraconducteur sous apport d'oxygène ou un procédé d'ablation au laser ou un procédé de pulvérisation ou un procédé de vaporisation chimique, notamment avec des composants organométalliques du matériau supraconducteur, ou un procédé de sérigraphie.

12. Procédé selon l'une des revendications 9 à 11, **caractérisé par le fait que**, pour le dépôt du matériau de couche intermédiaire, on prévoit un procédé de dépôt avec soutien par courant ionique (IBAD) ou un procédé de pulvérisation ou un procédé d'ablation au laser.

13. Dispositif limiteur de courant, **caractérisé par** au moins une structure supraconductrice (10, 20, 30) selon Tune des revendications 1 à 8.

14. Dispositif limiteur de courant selon la revendication 13, **caractérisé par** un regroupement électrique de plusieurs éléments limiteurs de courant modulaires (50i) qui ont chacun une structure supraconductrice selon l'une des revendications 1 à 8.

15. Dispositif limiteur de courant selon la revendication 14, **caractérisé par le fait que** chaque élément limiteur de courant (50i) comporte un enroulement (52) de conducteur en ruban (20, 20') enroulé, bifilaire, avec la structure supraconductrice.

16. Dispositif limiteur de courant selon la revendication 15, **caractérisé par** un enroulement de conducteur en ruban (52) avec des bandes isolantes (53), facilitant l'accès d'un fluide de refroidissement, entre des niveaux de conducteur en ruban adjacents.
